(19) **Europäisches Patentamt**

**European Patent Office**

**Office européen des brevets**

(11) **EP 1 643 633 A1**

(12) **EUROPÄISCHE PATENTANMELDUNG**

(43) Veröffentlichungstag:
05.04.2006 Patentblatt 2006/14

(51) Int Cl.:
*H03D 1/22* (2006.01)

(21) Anmeldenummer: 05020455.1

(22) Anmeldetag: 20.09.2005

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **04.10.2004 DE 102004048572**

(71) Anmelder: **Micronas GmbH**
**79108 Freiburg i. Br. (DE)**

(72) Erfinder:
• **Steinbach, Ingo**
**79104 Freiburg (DE)**
• **Fiesel, Hans**
**79194 Gundelfingen (DE)**
• **Temerinac, Miodrang**
**79194 Gundelfingen (DE)**

(74) Vertreter: **Göhring, Robert**
**Patentanwälte**
**Westphal, Mussgnug**
**Am Riettor 5**
**78048 Villingen-Schwenningen (DE)**

(54) **Schaltungsanordnung zur Unterdrückung einer Störung , sowie Verfahren**

(57) Die Erfindung betrifft ein Verfahren sowie eine Schaltungsanordnung (115) zur Unterdrückung einer störenden Quadraturkomponente eines Trägersignals eines amplitudenmodulierten Signals bei der Rückgewinnung des Trägersignals in einem Synchrondemodulator (15), welcher ein Quadratursignal (Q) ausgibt. Bei dem Verfahren ist erfindungsgemäß vorgesehen, dass die störende Quadraturkomponente des Trägersignals abgeschätzt wird und dass die abgeschätzte Quadraturkomponente von dem Quadratursignal (Q) subtrahiert wird. Die Schaltungsanordnung umfasst erfindungsgemäß eine Störungsabschätzeinrichtung (92) und eine Subtrahiereinrichtung (121) im Quadratur-Signal-Pfad (17).

FIG 4

**Beschreibung**

Die Erfindung betrifft ein Verfahren sowie eine Schaltungsanordnung zur Unterdrückung einer störenden Quadraturkomponente eines Trägersignals eines amplitudenmodulierten Signals bei der Rückgewinnung des Trägersignals in einem Synchrondemodulator, welcher ein Quadratursignal ausgibt.

Zum Empfang eines amplitudenmodulierten Signals (z.B. eines analogen Fernsehsignals) muss zunächst ein bestimmter Kanal ausgewählt werden, der mit Hilfe eines Tuners auf eine Zwischenfrequenz $f_{Z1}$ (z.B. $f_{Z1}$ = 38.9 MHz) gemischt wird. Um dieses Signal mit Hilfe digitaler Signalverarbeitung zu demodulieren, wäre ein A/D- Wandler (ADC = Akronym für analoge digital converter) sehr hoher Abtastrate $f_{AT1}$ und Auflösung $b_1$ notwendig (z.B. $f_{AT1}$ = 100 MHz/$b_1$ = 10 Bit). Deshalb wird das Signal auf eine zweite, niedrigere Zwischenfrequenz $f_{Z2}$ gemischt. Diese Zwischenfrequenz $f_{Z2}$ ist idealerweise eine Frequenz, die dem Kanalraster im HF-Band entspricht (z.B. $f_{Z2}$ = 7 MHz).

Entsprechende Frequenzselektion vorrausgesetzt kann das vorliegende Signal nun mit einer wesentlich geringeren Abtastfrequenz $f_{AT2}$ digital gewandelt werden. Das digitalisierte Signal wird mit Hilfe eines Synchron-Demodulators ins Basisband gemischt, wobei die Trägerfrequenz $f_T$ (vorzugsweise die Bildträgerfrequenz $f_{BT}$) durch eine voll-digitale phasenverriegelte Schleife (PLL = Akronym für phase-locked-loop) erzeugt wird. Durch weitere digitale Filterung der resultierenden In-Phase- und Quadraturkomponente wird das Signal (z.B. eine Bild- und/oder Toninformation extrahiert.

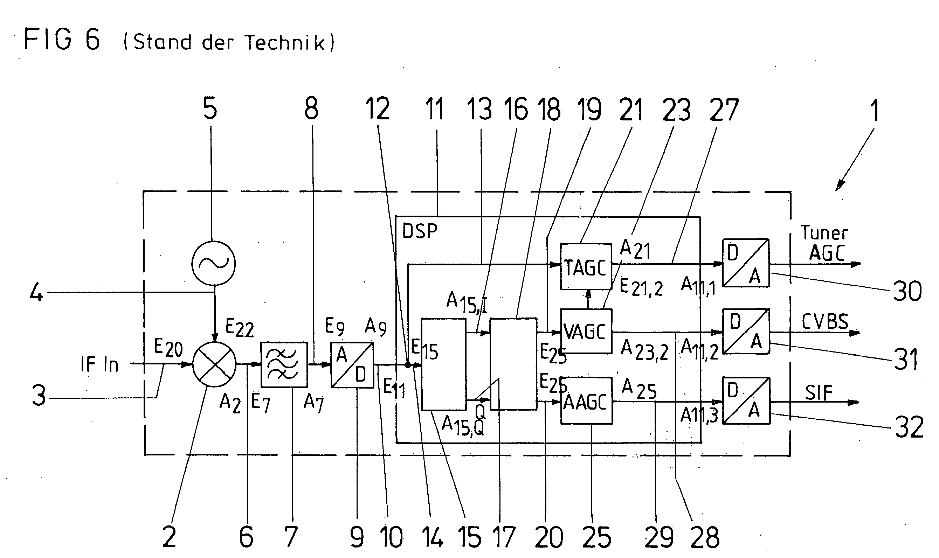

Fig. 6 zeigt beispielhaft einen prinzipiellen Aufbau eines digital realisierten TV-Empfängers 1 gemäß dem Stand der Technik. Der digitale TV-Empfänger 1 weist einen Eingang IF IN (Akronym für intermediate frequency input = Zwischenfrequenzeingang) sowie drei Ausgänge, nämlich Tuner- AGC (Akronym für Tuner Automatic Gain Control = automatische Verstärkungsregelung), CVBS (Akronym für Colour Video Blanking Signal (= FBAS Farb Bild Austast Sychronsignal)) und SIF (Akronym für Sound IF (= Ton-Zwischenfrequenz)) auf. Der Eingang IF IN ist über einen Signalpfad 3 mit einem ersten Eingang $E_{2,1}$ eines Mischers 2 verbunden. Ein lokaler Oszillator 5 ist über einen Signalpfad 4 mit einem zweiten Eingang $E_{2,2}$ mit dem Mischer 2 verbunden. Der Ausgang $A_2$ des Mischers 2 ist über einen Signalpfad 6 mit einem Eingang $E_7$ eines Bandpassfilters 7 verbunden. Ein Ausgang $A_7$ des Bandpassfilters 7 ist über einen Signalpfad 8 mit einem Eingang Eg eines Analog-Digital-Wandler 9 verbunden. Ein Ausgang $A_9$ des Analog-Digital-Wandlers 9 ist über einen Signalpfad 10 mit einem Eingang eines digitalen Signalprozessors 11 verbunden, welcher drei Ausgänge $A_{11,1}$, $A_{11,2}$ und $A_{11,3}$ aufweist.

Innerhalb des digitalen Signalprozessors 11 (DSP = Akronym für digital signal processor) teilt sich der Signalpfad 10 an einem Knotenpunkt 12 in zwei Teilsignalpfade 13 und 14 auf.

Der Teilsignalpfad 13 ist auf einen ersten Eingang $E_{21,1}$ einer automatischen Verstärkungsregeleinrichtung für Tuner (Kanalwähleinrichtung) Signale 21 geführt. Der zweite Teilsignalpfad 14 ist auf einen Eingang $E_{15}$ eines Synchron-Demodulators 15 geführt. Dieser Synchron- Demodulator 15 weist zwei Ausgänge auf, nämlich einen In-Phase-Signalausgang $A_{15,I}$ und einen Quadratursignalausgang $A_{15,Q}$. Beide Signalausgänge $A_{15,I}$ und $A_{15,Q}$ des Synchron-Demodulators 15 sind über entsprechende Signalpfade 16, 17 mit entsprechenden Eingängen $E_{18,I}$ und $E_{18,Q}$ einer Filtereinrichtung 18 verbunden. Diese Filtereinrichtung 18 weist selbst wiederum zwei Signalausgänge auf, nämlich einen In-Phase-Signalausgang $A_{18,I}$ und einen Quadratursignalausgang $A_{18,Q}$. Der In-Phase-Signalausgang $A_{18,I}$ der Filtereinrichtung 18 ist über einen Signalpfad 19 mit einem Eingang $E_{23}$ einer automatischen Verstärkungsregeleinrichtung für Videosignale 23 verbunden.

Diese automatische Verstärkungsregeleinrichtung für Videosignale 23 weist zwei Ausgänge auf, nämlich einen ersten mit dem Bezugszeichen $A_{23,1}$ und einen zweiten mit dem Bezugszeichen $A_{23,2}$ gekennzeichneten Ausgang.

Der erste Ausgang $A_{23,1}$ des der automatischen Verstärkungsregelungsrichtung für Videosignale 23 ist mit einem zweiten Eingang $E_{21,2}$ der automatischen Verstärkungsregelungseinrichtung für Tuner-Signale 21 verbunden. Dessen einziger Ausgang $A_{21}$ führt über einen Signalpfad 27 auf den vorstehend erwähnten ersten Ausgang $A_{11,1}$ des digitalen Signalprozessors 11.

Der zweite Ausgang $A_{23,2}$ der automatischen Verstärkungsregelungseinrichtung für Videosignale 23 ist über einen Signalpfad 28 mit dem vorstehend genannten zweiten Ausgang $A_{11,2}$ des digitalen Signalprozessors verbunden. Der Quadratur-Signalausgang $A_{18,Q}$ der Filtereinrichtung 18 ist über einen Signalpfad 20 mit einem Eingang $E_{25}$ einer automatischen Verstärkungsregelungseinrichtung 25 für Audiosignale verbunden. Dessen Ausgang $A_{25}$ ist über einen weiteren Signalpfad 29 mit dem dritten Ausgang $A_{11,3}$ des digitalen Signalprozessors 11 verbunden.

Sämtliche Ausgänge $A_{11,1}$, $A_{11,2}$, $A_{11,3}$ sind mit entsprechenden Eingängen $E_{30}$, $E_{31}$, $E_{32}$ dreier Analog-Digital-Wandler 30, 31, 32 verbunden. Deren Ausgänge bilden die vorstehend genannten Ausgänge Tuner AGC, CVBS, SIF des digitalen TV-Empfängers 1.

Im digitalen TV-Empfänger 1 werden folgende Operationen durchgeführt:

Das Ausgangssignal eines Tuners wird dem Eingang IF IN des digitalen TV-Empfängers 1 zugeführt. Dieses Signal wird mit Hilfe des lokalen Oszillators 5 (LO = Akronym für local oscillator) und des Mischers 2 auf eine zweite Zwischenfrequenz, die sogenannte Second IF, umgesetzt.

Dieses Second IF-Signal liegt am Ausgang $A_2$ des Mischers 2 an. Es wird über den Eingang $E_7$ dem Band-

passfilter 7 zugeführt. Nach der Bandpassfilterung sind unerwünschte Mischprodukte aus dem Signal entfernt und es kann ohne Signalverkennung, d. h. ohne sogenanntes Aliasing, mit Hilfe des Analog-Digital-Wandlers 9 digitalisiert werden.

Im Digitalteil 11 (DSP = Akronym für digital signal processor) wird das Signal zunächst mit Hilfe des Synchron-Demodulators 15 ins Basisband gemischt. An den Ausgängen $A_{15,I}$, $A_{15,Q}$ des Synchron-Demodulators 15 liegen demodulierte In-Phase- bzw. Quadratur-Signale I, Q vor. Durch weitere Filterung und verschiedene weitere Algorithmen in der Filtereinrichtung 18 werden aus den I/Q-Daten das Videosignal und das Ton-ZF-Signal gewonnen. Mit Hilfe der Tuner-AGC 21 (=Akronym für automatic gain control) wird der Tunerausgangspegel so eingestellt, dass der am Eingang $E_{11}$ des $DSP_s$ 11 angeschlossene A/D-Wandler 9 nicht übersteuert wird. Mit Hilfe der an den Ausgängen $A_{18,I}$, $A_{18,Q}$ angeschlossenen VAGC 23 und AAGC 25 (Akronym für video AGC und audio AGC) werden die Signale für die D/A-Wandler 31,32 optimal ausgesteuert.

Betrachtet man den Idealfall eines dem Eingang Eg des Analog-Digitalwandlers 9 zugeführten 2nd IF-Signals mit kosinusförmigem Bildträgersignal mit der Bildträgerfrequenz $f_{BT}$, kosinusförmigem Bildinformationssignal mit der Bildinformationsfrequenz $f_{picture}$ sowie kosinusförmigem Tonträgersignal mit der Tonträgerfrequenz $f_{TT}$ und kosinusförmigem Toninformationssignal mit der Toninformationsfrequenz $f_{sound}$, so lässt sich dieses mit Hilfe der folgenden Gleichung beschreiben:

$$u(t) = \underbrace{\hat{u}_{BT} \cdot \cos(2\pi f_{BT} t) \cdot \left(1 + m \cdot \cos(2\pi f_{picture} t)\right)}_{Bild\,(AM-Modulation)} + \underbrace{\hat{u}_{TT} \cdot \cos(2\pi f_{TT} t + \Delta\varphi_{TT} \cdot \cos(2\pi f_{Sound} t))}_{Ton\,(FM-Modulation)} \qquad (\text{Gl. 1})$$

mit:

| | |
|---|---|
| $\hat{u}_{BT}$ | Bildträgeramplitude |
| m | Modulationsindex |
| $\hat{U}_{TT}$ | Tonträgeramplitude |
| $\Delta\varphi_{TT}$ | Phasenhub der FM-Modulation |

Der Tonträger ist für die Bildträgeraufbereitung irrelevant und wird innerhalb der Trägerrückgewinnung ausgefiltert. Nach der Filterung ergibt sich ein Signal, welches durch die nachfolgende Gleichung beschreibbar ist:

$$u(t) = \underbrace{\hat{u}_{BT} \cdot \cos(2\pi f_{BT} t) \cdot \left(1 + m \cdot \cos(2\pi f_{picture} t)\right)}_{Bild\,(AM-Modulation)} \qquad (\text{Gl. 2})$$

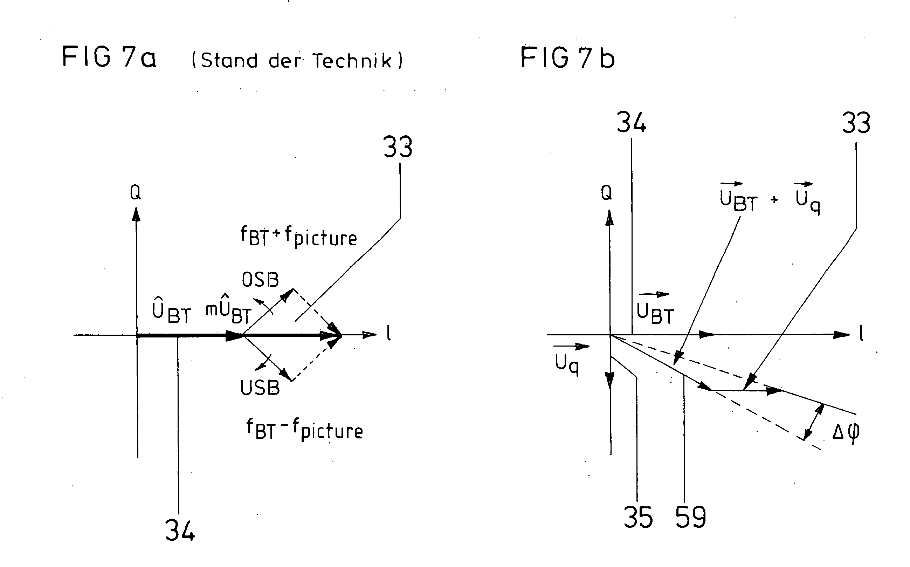

Die Figur 7a) zeigt das Zeigerdiagramm dieses amplitudenmodulierten Signals. In diesem Fall ist die Trägerrückgewinnung auf die Summe aus dem Bildträger 34 und den beiden die Bildinformation 33 repräsentierenden Seitenbändern OSB, USB (OSB = Akronym für oberes Seitenband, USB = Akronym für unteres Seitenband) eingerastet.

Zum Beispiel durch Unsymmetrie im Sendemodulator oder in der analogen Signalverarbeitung des TV-Empfängers 1 kann der Bildträger 34 durch eine orthogonale Komponente 35 gestört sein. Aus (Gl. 2) wird damit:

$$u(t) = \underbrace{\left(\hat{u}_{BT} \cdot \cos(2\pi f_{BT} t) + \hat{u}_q(t) \cdot \sin(2\pi f_{BT} t)\right) \cdot \left(1 + m \cdot \cos(2\pi f_{picture} t)\right)}_{Bild\,(AM-Modulation)} \qquad (\text{Gl. 3})$$

mit:

| | |
|---|---|
| $\hat{u}_q(t)$ | Amplitude der Störkomponente |

In der entsprechenden Zeigerdarstellung, welche sich aus Figur 7b) ergibt, zeigt sich dies darin, dass bei Amplitudenänderungen der Information 33 eine Phasenmodulation $\Delta\varphi$ auftritt. Bei der Trägerrückgewinnung muss diese Phasenmodulation $\Delta\varphi$ möglichst exakt ausgeglichen werden.

Demodulatoren gemäß dem betriebsintern bekannten Stand der Technik werden so dimensioniert, dass die Phasenmodulation durch die Trägeraufbereitung ständig nachgeregelt wird. Dies hat zum Einen zur Folge, dass durch schnelles Folgen des Bildträgers zwar die Information auch bei Existenz einer orthogonalen Trägerkomponente korrekt rekonstruiert wird, weil aber z.B. beim analogen Fernsehen der Tonträger mit Hilfe des rekonstruierten Bildträgers auf die Tonzwischenfrequenz gemischt wird, unterliegt dieser den gleichen Frequenzänderungen, was sich in einer zusätzlichen Frequenzmodulation äußert; zum Anderen wird durch die große benötigte Bandbreite der Trägerregelung auch Rauschen ausgeregelt, was sich in einer Verschlechterung des Signal-Rausch-Verhältnisses SNR (SNR = Akronym für signal to noise ratio) niederschlägt.

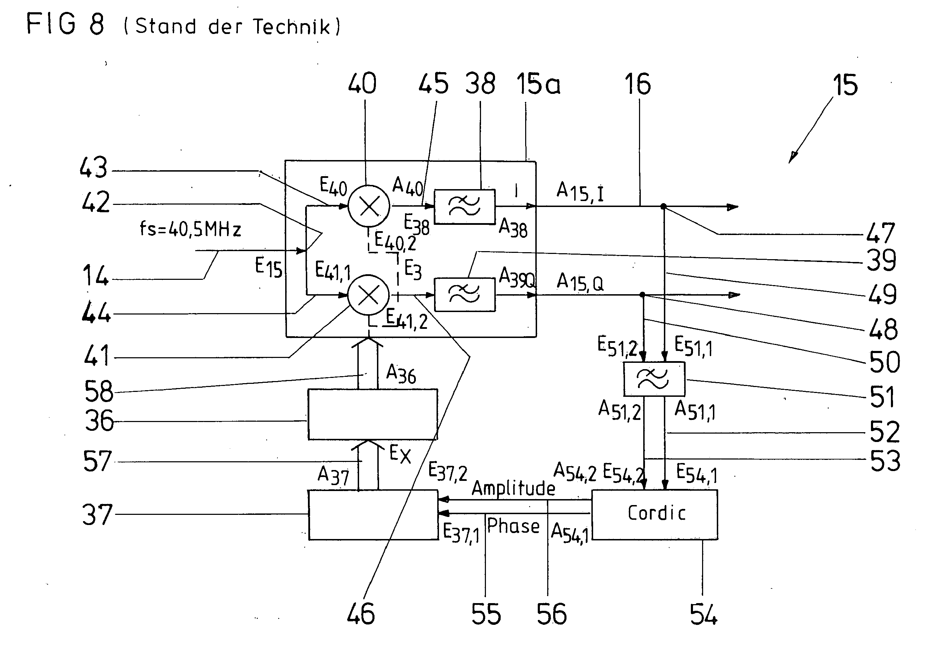

Die digitale Trägeraufbereitung im Digitalsignalprozessor 11 gemäß der Figur 6 wie er gemäß dem betriebsintern bekannten Stand der Technik realisiert ist, ist in Form eines Blockschaltbilds in der Figur 8 dargestellt.

Insbesondere entnimmt man der Figur 8 den Synchron-Demodulator 15 aus Figur 6. Der Synchron-Demodulator 15 besteht aus dem eigentlichen I/Q- Demodulator 15a, welcher ein Eingangssignal in ein In-Phase-Signal I und ein Quadratursignal Q umsetzt. Darüber hinaus ist eine Schaltungsanordnung vorgesehen, welche aus dem In-Phase-Signal I und dem Quadratursignal Q das Bildträgersignal BT gewinnt und einem ersten Mischer 40 des I/Q-Demodulators 15a unmittelbar und einem zweiten Mischer 41 des I/Q-Demodulators 15a mit 90° Phasenverschiebung zuführt.

Konkret ist der I/Q-Demodulator 15a in an sich üblicher Weise aufgebaut. Er umfasst einen Eingang $E_{15}$ und zwei Ausgänge, nämlich einen In-Phase-Signalausgang $A_{15,I}$ und einen Quadratursignal-Ausgang $A_{15,Q}$. Der Eingang $E_{15}$ ist über einen Signalpfad 14 mit einem Knotenpunkt 42 verbunden. Diesen Knotenpunkt 42 spaltet der Signalpfad 14 in zwei Teilsignalpfade 43 und 44 auf. Der erste Teilsignalpfad 43 ist mit einem Eingang $E_{40}$ des vorstehend genannten ersten Mischers 40, der zweite Teilsignalpfad 44 ist mit einem ersten Eingang $E_{41,1}$ des vorstehend genannten zweiten Mischers 41 verbunden. Beide Mischer 40, 41 weisen jeweils einen weiteren zweiten Eingang $E_{40,2}$, $E_{41,2}$ auf, denen die Bildträgersignale BT in der vorstehend genannten Weise zugeführt werden.

Ein Ausgang $A_{40}$ des Mischers 40 ist über einen Signalpfad 45 mit einem Eingang $E_{38}$ eines Tiefpassfilters 38 verbunden. Ein Ausgang $A_{41}$ des Mischers 41 ist über einen Signalpfad 46 mit einem Eingang $E_{39}$ eines zweiten Tiefpasses 39 verbunden.

Ein Ausgang $A_{38}$ des ersten Tiefpasses 38 bildet den vorstehend genannten In-Phase-Signalausgang $A_{15,I}$, ein Ausgang $A_{39}$ des zweiten Tiefpasses 39 bildet den vorstehend angegebenen Quadratursignal-Ausgang $A_{15,Q}$ des I/Q-Demodulators A.

Der Ausgang $A_{15,I}$ führt über einen Signalpfad 16 auf einen Knotenpunkt 47. Von diesem Knotenpunkt 47 führt ein Signalpfad einerseits auf den in der Figur 6 dargestellten Filter 18 sowie über einen Signalpfad 41 auf einen ersten Eingang $E_{41,1}$ eines Tiefpassfilters 51.

Der Quadratursignal-Ausgang $A_{15,Q}$ führt über einen Signalpfad 17 auf einen Knoten 48. Von diesem Knoten 48 führt einerseits eine Signalverbindung weiter zum in der Figur 6 dargestellten Filter 16 und andererseits über einen Signalpfad 50 auf einen zweiten Eingang $E_{51,2}$ des vorstehend genannten Tiefpassfilters 51.

Zu den vorstehend angegebenen Eingängen $E_{51,1}$ bzw. $E_{5,2}$ des Tiefpassfilters 51 korrespondierende Ausgänge $A_{51,1}$, bzw. $A_{51,2}$ führen weiter über entsprechende Signalpfade 52, 53 zu entsprechenden Eingängen $E_{54,1}$, $E_{54,2}$ einer Recheneinheit 54.

Zwei Ausgänge $A_{54,1}$, $A_{54,2}$ dieser Recheneinheit 54 sind über entsprechende Signalpfade 55, 56 mit Eingängen $E_{37,1}$, $E_{37,2}$ einer Regeleinrichtung 37 verbunden.

Ein oder mehrere Ausgänge $A_{37}$ der Recheneinheit 37 sind über entsprechende Signalpfade 57 mit den entsprechenden Eingängen $E_{36}$ eines digitalen I/Q-Oszillators 36 verbunden. Ausgehend von entsprechenden Ausgängen $A_{36}$ des I/Q-Oszillators 36 führen Signalpfade 58 zu den Eingängen $E_{40,2}$ und $E_{41,2}$ der Mischer 40 bzw. 41.

Der Tiefpassfilter 51 selektiert den Bildträger, der hier im Basisband ($f_{BT} \approx 0$ HZ) liegt. Der darauffolgende CORDIC (Coordinate Rotation Digital Computer) 54 ermittelt aus den tiefpassgefilterten I/Q Wertepaaren (Signale 52/53) die Phase 55 und die Amplitude 56. Die Phase 55 stellt die Phasendifferenz zwischen dem Bildträger des empfangenen Signals 14 und dem lokalen Träger 58 des I/Q-Oszillators 36 dar. Die Phase 55 wird im Block 37 zu einem Korrektursignal 57 umgerechnet, um den lokalen I/Q-Oszillator 36 nachzuführen. Nach mehreren Iterationen (Schleifendurchläufen) wird sich der Träger 58 an den empfangenen Träger 14 angleichen.

Bei der vorstehend beschriebenen digitalen Realisierung der Trägerregelung kann nur schwer eine der analogen Lösung vergleichbare Bandbreite erreicht werden. Die Bandbreite ist begrenzt durch die relativ große Signalverzögerung innerhalb der Regelschleife (Filterung, Phasen- und Amplitudenmessung mit Cordic-Algorithmus).

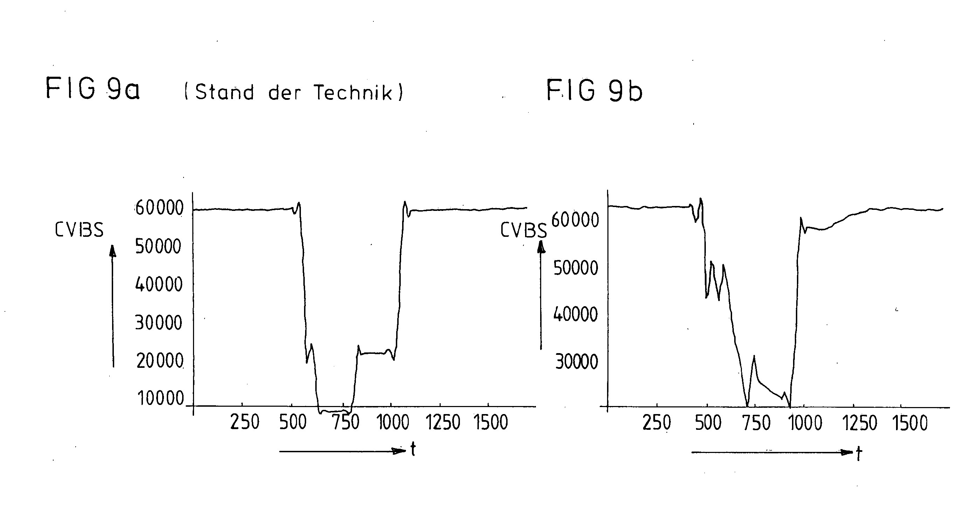

Beim Empfang eines analogen Fernsehsignals hat dies Auswirkungen auf das demodulierte Video-Signal sowie auf den demodulierten Tonträger, da dieser durch das Nachregeln der PLL zusätzlich frequenzmoduliert wird. Fig. 9 zeigt die Auswirkungen einer Quadraturkomponente im In-Phase-Signal auf das demodulierte Videosignal.

Der Tonträger wird mit Hilfe des lokalen I/Q-Oszillators 36 auf die Ton-Zwischenfrequenz umgesetzt. Falls aufgrund einer orthogonalen Störkomponente des Bildträgers eine Phasenmodulation des Bildträgers auftritt, wirkt sich diese als Frequenzmodulation des Ton-Zwischenfrequenzträgers aus, da der lokale Träger 58 der Phasenmodulation folgt.

Fig. 9 zeigt einen Ausschnitt aus einem CVBS-Signal. In Fig. 9a ist deutlich der horizontale Synchronisations-Impuls erkennbar (ca. bei 650<t<750). Fig. 9b zeigt denselben Fall mit zusätzlicher orthogonaler Störkomponente. Die PLL-Schleife ist in diesem Fall nicht schnell genug, um das Signal fehlerfrei zu demodulieren. Der horizontale Synchronisationsimpuls ist soweit verzerrt, sodass ein angeschlossenes TV-Gerät kein stabiles Bild daraus generieren kann.

Aufgabe dieser Erfindung ist es, ein Verfahren sowie eine Schaltungsanordnung bereitzustellen bei dem bzw. bei der bei der Trägeraufbereitung auch bei schlecht abgeglichenen Sendern eine störungsfreie Demodulation des Signals gewährleistet wird. Darüber hinaus soll ein Verfahren sowie eine Schaltungsanordnung zur orthogonalen Störungsabschätzung und deren Kompensation bereitgestellt werden.

Diese Aufgabe wird durch Verfahren mit den Merkmalen der Patentansprüche 1 und 9 bis 13 sowie durch Schaltungsanordnungen mit den Merkmalen der Patentansprüche 14 und 22 bis 25 erfindungsgemäß gelöst.

Vorteilhafte Ausführungen und Weiterbildungen der Erfindung sind in den Unteransprüchen angegeben.

Bei dem Verfahren zur Unterdrückung einer störenden Quadraturkomponente eines Trägersignals eines amplitudenmodulierten Signals bei der Rückgewinnung des Trägersignals in einem Synchrondemodulator, welcher ein Quadratursignal ausgibt, ist erfindungsgemäß vorgesehen, dass die störende Quadraturkomponente des Trägersignals abgeschätzt wird und dass die abgeschätzte Quadraturkomponente von dem Quadratursignal subtrahiert wird. Die Schaltungsanordnung umfasst erfindungsgemäß eine Störungsabschätzeinrichtung und eine Subtrahiereinrichtung im Quadratur-Signal-Pfad.

Anders ausgedrückt ist also erfindungsgemäß vorgesehen, die im Signal enthaltene orthogonale Trägerkomponente zu Messen und innerhalb der Trägerregelung zu kompensieren. Die Bandbreite der PLL muss damit nicht verändert werden, um die Information ohne Qualitätseinbußen zu demodulieren, um im Beispiel des analogen Fernsehens zu verhindern, dass ein frequenzmoduliertes Tonsignal durch die Existenz einer orthogonalen Bildträgerkomponente gestört wird.

Die Erfindung wird nunmehr anhand der Zeichnung näher beschrieben. Zur Kennzeichnung gleicher oder funktionsgleicher Bestandteile sind in den Figuren identische Bezugszeichen verwendet worden. Es zeigen:

Figur 1: ein Zeigerdiagramm eines modulierten Fernsehsignal- Bildträgers mit Störkomponente vor und nach einem Amplitudensprung des Informationssignals

    a) Sprung von kleiner Signalamplitude auf große Signalamplitude,
    b) Sprung von großer Signalamplitude auf kleine Signalamplitude,

Figur 2: zeitliche Verläufe charakteristischer I/Q-demodulierter Fernsehsignale und von diesen abgeleitete Signale zur Abschätzung der orthogonalen Störkomponente des Bildträgers

    a) Inphase-Signal (ungefähr gleich Amplitude von I/Q),
    b) Regelabweichung des Quadratur-Signals,
    c) Differentielle Änderung des Informationssignals,
    d) differentielle Regelabweichung des Inphase-Signals,
    e) Multiplikation der Änderung des Informationssignals und der differentiellen Regelabweichung des Quadratur-Signals,

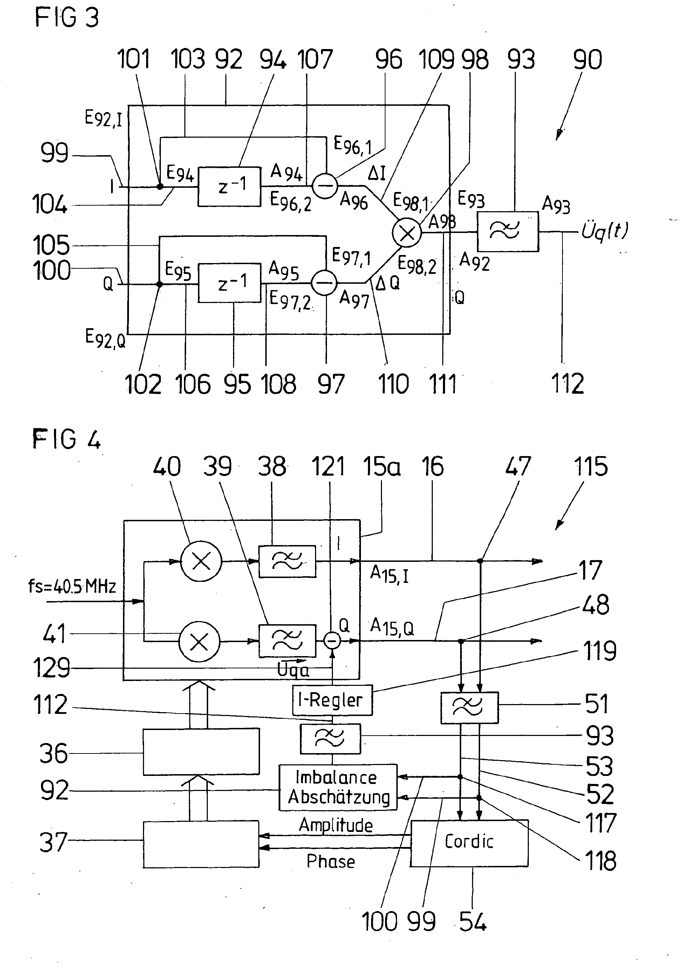

Figur 3: ein Blockschaltbild einer digitalen Schaltungsanordnung zur orthogonalen Störungsabschätzung,

Figur 4: ein Blockschaltbild eines Synchron-Demodulators mit Trägeraufbereitungseinrichtung und erfindungsgemäßer Einrichtung zur Abschätzung und Kompensation einer orthogonalen Störung,

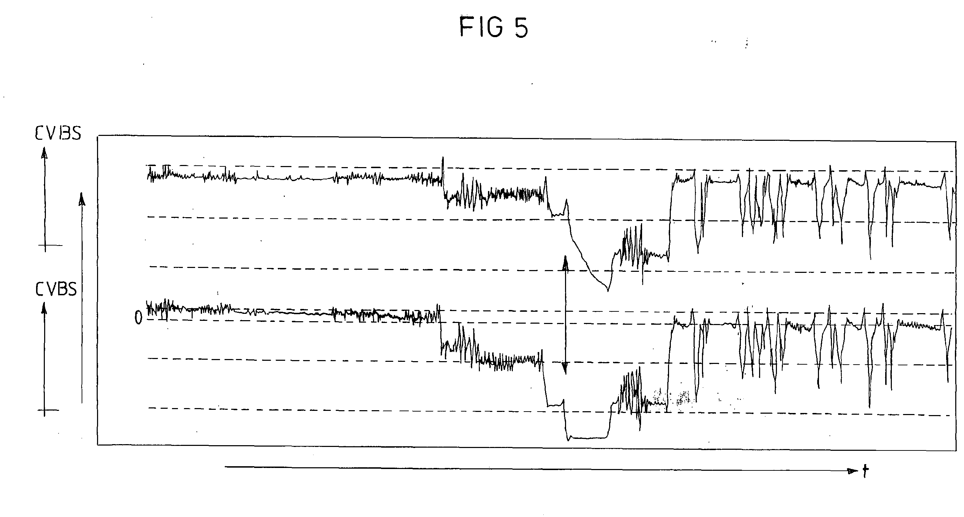

Figur 5: ein Simulationsergebnis einer erfindungsgemäßen Imbalance-Kompensation,

Figur 6: ein Blockschaltbild eines TV-Empfängers gemäß dem Stand der Technik,

Figur 7: ein Zeigerdiagramm eines amplitudenmodulierten Fernsehsignal-Bildträgers (Stand der Technik)

    a) ohne Störkomponente,
    b) mit Störkomponente,

Figur 8: ein Blockschaltbild eines Synchron-Demodulators mit Trägeraufbereitungseinrichtung gemäß dem Stand der Technik,

Figur 9:     Auswirkungen einer orthogonalen Störung auf ein demoduliertes Videosignal (Stand der Technik).

Die orthogonale Störkomponente, welche in der englischen Fachsprache als "modulator imbalance" bezeichnet wird, kann wie folgt abgeschätzt werden:

Die orthogonale Störkomponente erscheint als Gleichspannungswert im Q-Pfad nach dem I/Q-Mischer. Die Trägerrückgewinnung interpretiert dies als Phasenfehler (gemessen mit Cordic) und regelt damit den digitalen I/Q-Oszillator auf einen vermeintlich richtigen Wert. Bei einem Amplitudensprung des ZF-Signals (z.B. bei einem Wechsel des Bildinhalts von Weiß nach Schwarz im Falle eines Fernsehsignals) wird wiederum kurzzeitig ein Gleichsignal im Q-Pfad sichtbar, das zurückgeregelt wird. Die Größe des Ausschlags des Gleichsignals im Q-Pfad hängt von der Größe und Richtung des Amplitudensprungs ab.

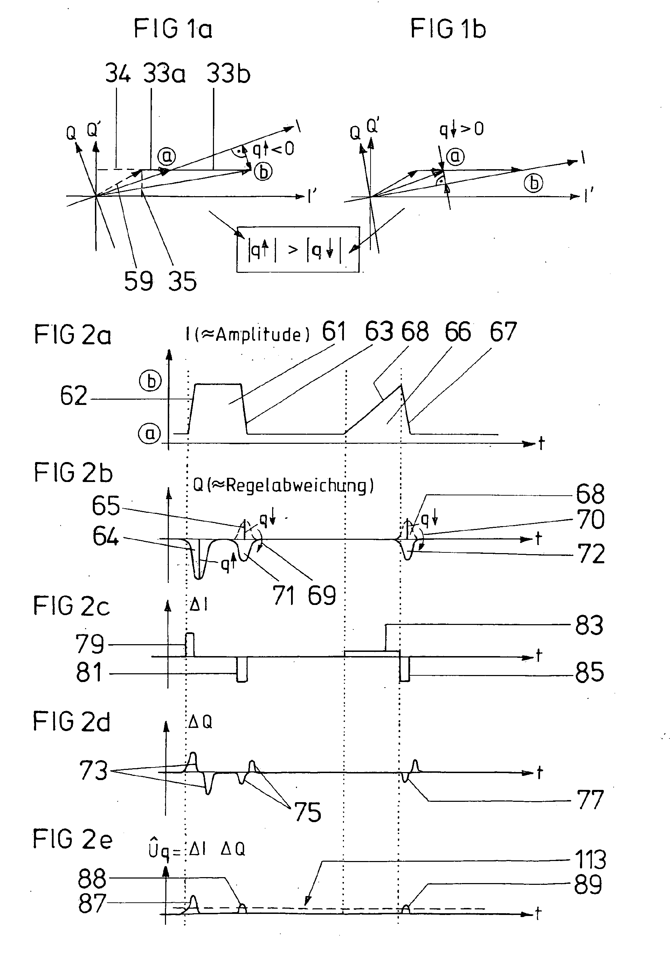

Das Zeigerdiagramm in Fig. 1 verdeutlicht diesen Zusammenhang am Beispiel des Fernsehsignals:

Das gestrichene Koordinatensystem I'/Q' zeigt die Zusammensetzung 59 eines modulierten Bildträgers 34 mit Störkomponente 35 Punkt (a) stellt das Signal bei kleiner Informationssignalamplitude 3a (z.B. Weißpegel bei analog TV) dar und Punkt (b) zeigt eine große Informationssignalamplitude 33b (z.B. Schwarzpegel). Das andere Koordinatensystem I/Q zeigt das momentan gültige Koordinationssystem der Trägerrückgewinnung im eingerasteten Zustand. Bei der Signaländerung von Punkt (a) nach (b) erhält man zunächst einen negativen Q-Wert q↑. Im umgekehrten Fall erhält man einen positiven Q-Wert q↓. Wie aus Fig. 1 ersichtlich gilt dabei die einfache Beziehung:

$$\left| q\uparrow \right| > \left| q\downarrow \right| \qquad\qquad\qquad (\text{Gl. 4})$$

Würden positive Sprünge 62 und negative Sprünge 63 wie z.B. bei einem (nahezu) rechteckförmigen Informationssignal 61 (Fig. 2a) gleich häufig vorkommen, könnte durch diese Beziehung die orthogonale Störkomponente 35 durch einfache Integration (Integrale 64 und 65 in Fig. 2b) des Q-Werts q↑, q↓ geschätzt werden. Dies kann aber zum Beispiel bei einer analogen TV-Übertragung nicht sichergestellt werden.

Hat man z.B. ein Informationssignal 66 in Form eines Sägezahns (Video-Bild: Graukeil; Fig. 2a), dann treten zur Abschätzung der orthogonalen Störkomponente 35 mittels des Integrals 68 des Q-Werts q↑, q↓ (Fig. 2b) notwendige Amplitudensprünge 67 lediglich in eine Richtung auf. Die Amplitudenänderung 68 in die andere Richtung ist kontinuierlich und die daraus resultierende Phasenmodulation kann von der Trägerrückgewinnung kontinuierlich nachgeregelt werden (q↑ = q↓ = 0 während Flanke 68 in Fig. 2b). In diesem Fall ist die Schätzung der Störkomponente unzuverlässig. Daher ist es vorteilhaft, die Integration 67,71,72 des Q-Werts, mit dem Vorzeichen 69,70 der vorangegangenen Amplitudenänderung zu korrigieren.

Im Idealfall wird die Amplitudenänderung mit Hilfe des Absolutwerts aus dem momentanen I-und Q-Wert ermittelt. Eine aufwandsgünstigere Lösung erhält man - unter Annahme, dass die Trägerrückgewinnung eingerastet ist - indem nur die Änderung des I-Teils ausgewertet wird, wie in Fig. 2 beispielhaft dargestellt ist.

Um die Messung robust gegen Phasenänderungen des Bildträgers zu machen, ist es vorteilhaft, die differentiellen Regelabweichungen

$$\Delta Q = \frac{dQ(t)}{dt} \qquad\qquad\qquad (\text{Gl. 5})$$

für die Schätzung zu benutzen. Die Figur 2d zeigt die aus den entsprechenden Amplitudenänderungen 62,63,68,67 des In-Phase-Signals I ermittelten differentiellen Amplitudenänderungen 79,81,83,85. Das Schätzergebnis erhält man mit Hilfe der differentiellen Amplitudenänderung

$$\Delta I = \frac{dI(t)}{dt} \qquad\qquad\qquad (\text{Gl. 6})$$

der In-Phase-Komponente aus der Gleichung

$$\hat{U}_Q = \overline{\Delta I(t) \cdot \Delta Q(t)} \qquad\qquad\text{(Gl. 7)}$$

und für das beschriebene Beispiel aus der Figur 2e). Hierin sind die für die oben genannten Amplitudensprünge des In-Phase-Signals ermittelten Schätzwerte durch die Bezugzeichen 87,88 und 89 gekennzeichnet.

Simulationen zeigen, dass die Messung der Störkomponente sehr großen Schwankungen unterliegt und außerdem sehr stark von der gesendeten Information abhängt, da die Effekte der Störkomponente nur bei Amplitudensprüngen der Information sichtbar werden. Deshalb wird das Messergebnis zusätzlich tiefpassgefiltert. Die Tiefpassfilterung ist in der Figur 2e) mit Hilfe des Bezugzeichens 113 gekennzeichnet.

Dieses vorstehend beschriebene Verfahren lässt sich mit Hilfe der in der Figur 3 dargestellten digitalen Schaltungsanordnung 90 z.B. bei der in Fig. 8 gezeigten Schaltungsanordnung 15 implementieren.

Durch Simulation der Regelung im Gesamtsystem wurde die Funktion nachgewiesen. Der Effekt ist z.B. bei analogen TV-Signalen besonders gut erkennbar bei Bildinhalten mit Weißpegeln am Ende einer Video-Zeile. Wenn eine starke orthogonale Störkomponente vorhanden ist, wird dadurch am Zeilenende bzw. am Beginn der nächsten Zeile der Zeilensynchronisationsimpuls gestört und dadurch nachfolgende Zeilen horizontal verzerrt.

Fig. 5 zeigt wie Fig. 9 den Ausschnitt eines CVBS-Signals. Das Signal enthält eine relativ starke orthogonale Störkomponente und wird wie schon zuvor beschrieben bei horizontalem Synchronisationsimpuls (markiert durch den Pfeil) verzerrt (Fig. 9 oben) und ein angeschlossenes TV-Gerät würde daraus kein stabiles TV-Bild generieren können. Im Unterschied dazu ist bei Fig. 9 unten die Imbalance Kompensations Regelung aktiv und bereits auf einen Endwert eingeschwungen. Die orthogonale Störkomponente ist vollständig kompensiert und das Signal wird fehlerfrei demoduliert.

Diese Schaltungsanordnung lässt sich in einen aus dem Stand der Technik bekannten Synchron-Demodulator implementieren. Die Figur 4 zeigt einen Synchron-Demodulator 115 mit orthogonaler Störungskompensation. Der Synchron-Demodulator 115 gemäß der Figur 4 umfasst zum einen die Schaltungskomponenten des Synchron-Demodulators 15 gemäß der Figur 8 sowie eine implementierte Schaltungsanordnung zur orthogonalen Störungsabschätzung. Diese Schaltungsanordnung zur orthogonalen Störungsabschätzung kann beispielsweise identisch ausgeführt sein wie die Schaltungsanordnung 90 gemäß der Figur 3.

Im vorliegenden Ausführungsbeispiel sind die Signalpfade 52, 53 zwischen Tiefpassfilter 51 und Recheneinheit 54 über entsprechende Knotenpunkte 117, 118 mit den Signalpfaden 99, 100 der Schaltungsanordnung 90 gemäß der Figur 3 verbunden. Am Ausgang $A_{93}$ der Schaltungsanordnung 90 ist über einen Signalpfad 112 eine Verbindung zu einem Eingang $E_{119}$ eines I-Reglers 119 hergestellt.

Ein Ausgang $A_{119}$ führt ein Signalpfad 120 zu einem zweiten Eingang $E_{121}$ eines Subtrahierers, dessen erster Eingang $E_{121}$ mit dem Ausgang $A_{39}$ des Tiefpasses 39 im Q-Pfad verbunden ist.

Mit Hilfe des I-Reglers 119 wird das tiefpassgefilterte Schätzsignal $\vec{U}_{qa}$ mit der Amplitude $\hat{U}_{qa}$ vom Quadratursignal Q im Q-Pfad subtrahiert und damit kompensiert. Es versteht sich für den Fachmann von selbst, dass anstelle des I-Reglers 119 auch jede andere Regelschleife eingesetzt werden könnte.

I-Regler wird das Signal 112 zunächst mit einem einstellbaren Faktor verstärkt bzw. gedämpft und dann einem Integrier-Glied zugeführt. Mit Hilfe des Faktors wird die Geschwindigkeit der Regelschleife beeinflusst. Der aktuelle Zustand des Integrier-Glieds ist zugleich das Schätzsignal $\vec{U}_{qa}$.

Im Zusammenhang mit Fig. 3 wird noch auf Folgendes hingewiesen.

Die Regelabweichung wird hervorgerufen durch die störende orthogonale Komponente, da diese zu der beschriebenen Phasenmodulation führt. Durch Integration (und Vorzeichenkorrektur) wird aus der Regelabweichung die Quadraturkomponente abgeschätzt. Dies funktioniert nur mit einer Regelschleife, da es keine Möglichkeit gibt, die orthogonale Störkomponente direkt zu berechnen.

Die eigentliche Störungsabschätzung ist gemäß Bezugzeichen 90 definiert. Durch Benutzung des Filters 93 wird das Schätzergebnis zuverlässiger. Allerdings wird die Störungsabschätzung 90 alleine nicht den absoluten Wert der Störkomponente ermitteln können. Es ist nur möglich, eine Tendenz zu ermitteln. Diese Tendenz wird durch Aufladen oder Entladen des Integrierers im I-Regler 119 genutzt, um im eingeschwungenen Zustand der Regelschleife den absoluten Wert der Störkomponente zu erhalten.

Bezugszeichenliste

| | |
|---|---|
| 1 | digitaler TV-Empfänger |
| 2 | Mischer |
| 3 | Signalpfad |
| 4 | Signalpfad |
| 5 | lokaler Oszillator (LO) |
| 6 | Signalpfad |
| 7 | Bandpassfilter |
| 8 | Signalpfad |
| 9 | Analog-Digital-Wandler (ADC) |
| 10 | Signalpfad |
| 11 | digitaler Signal Prozessor (DSP) |
| 12 | Knotenpunkt |
| 13 | Signalpfad |
| 14 | Signalpfad |
| 15 | Synchron-Demodulator |
| 15a | I/Q-Demodulator |
| 16 | Signalpfad |
| 17 | Signalpfad |
| 18 | Filtereinrichtung |
| 19 | Signalpfad |
| 20 | Signalpfad |
| 21 | automatische Verstärkungsregeleinrichtung für den Tuner-Ausgangspegel (Tuner-AGC) |
| 23 | automatische Verstärkungsregeleinrichtung für Videosignale (VAGC) |
| 25 | automatische Verstärkungsregeleinrichtung für Audiosignale (AAGC) |
| 27 | Signalpfad |
| 28 | Signalpfad |
| 29 | Signalpfad |
| 30 | Digital/Analog-Wandler (DAC) |
| 31 | Digital/Anagog-Wandler |
| 32 | Digital/Analog-Wandler |
| 33 | Bildinformation |
| 33a | Bildsignal mit kleiner Amplitude (m<1) |
| 33b | Bildsignal mit großer Amplitude (m>1) |
| 34 | Bildträger |
| 35 | Störkomponente (modulator imbalance) |
| 36 | digitaler I/Q-Oszillator |
| 37 | Regeleinrichtung |
| 38 | IN-Phase-Signal-Tiefpassfilter |
| 39 | Quadratur-Signal-Tiefpassfilter |
| 40 | erster Mischer |
| 41 | zweiter Mischer |
| 43 | Signalpfad |
| 44 | Signalpfad |
| 45 | Signalpfad |
| 46 | Signalpfad |
| 47 | Knotenpunkt |
| 48 | Knotenpunkt |
| 49 | Signalpfad |
| 50 | Signalpfad |
| 51 | Tiefpassfilter |
| 52 | Signalpfad |
| 53 | Signalpfad |
| 54 | Recheneinheit |
| 55 | Signalpfad |
| 56 | Signalpfad |
| 57 | Signalpfad |
| 58 | Signalpfad |
| 59 | Vektorsumme aus Bildträger und Störkomponente |

| 61 | rechteckförmiges Informationssignal |
|---|---|
| 62 | positiver Sprung |
| 63 | negativer Sprung |
| 64 | Integral |
| 65 | Integral |
| 66 | sägezahnförmiges Informationssignal |
| 67 | Amplitudensprung |
| 68 | Integral |
| 69 | Vorzeichenkorrektur |
| 70 | Vorzeichenkorrektur |
| 71 | Integral |
| 72 | Integral |
| 73 | differentielle Regelabweichung wegen positivem Sprung 62 |
| 75 | differentielle Regelabweichung wegen negativem Sprung 63 |
| 77 | differentielle Regelabweisung wegen negativem Sprung 67 |
| 79 | zeitlicher Amplitudenanstieg bei positivem Sprung 62 |
| 81 | zeitlicher Amplitudenabfall bei negativem Sprung 63 |
| 83 | zeitlicher Amplitudenanstieg bei positiver Flanke 68 |
| 85 | zeitlicher Amplitudenabfall bei negativem Sprung 67 |
| 87 | Schätzwert |
| 88 | Schätzwert |
| 89 | Schätzwert |
| 90 | Schaltungsanordnung zur orthogonalen Störungsabschätzung |
| 92 | Schätzwertbildner |
| 93 | Tiefpassfilter |
| 94 | erstes Verzögerungsglied |
| 95 | zweites Verzögerungsglied |
| 96 | erster Subtrahierer |
| 97 | zweiter Subtrahierer |
| 98 | Multiplizierer |
| 99 | In-Phase-Signalpfad |
| 100 | Quadratur-Signalpfad |
| 101 | Knotenpunkt |
| 102 | Knotenpunkt |
| 103 | erster In-Phase-Signal-Teilpfad |
| 104 | zweiter In-Phase-Signal-Teilpfad |
| 105 | erster Quadratur-Signal-Teilpfad |
| 106 | zweiter Quadratur-Signal-Teilpfad |
| 107 | erster Verzögerungssignalpfad |
| 108 | zweiter Verzögerungssignalpfad |
| 109 | Signalpfad |
| 110 | Signalpfad |
| 111 | Signalpfad |
| 112 | Signalpfad |
| 113 | Tiefpassfilterung |
| 115 | Synchron-Demodulator mit orthogonaler Störungskompensation |
| 117 | Knotenpunkt |
| 118 | Knotenpunkt |
| 119 | I-Regler |
| 120 | Signalpfad |
| 121 | Subtrahierer |

| IF IN | Zwischenfrequenzeingang |
|---|---|
| Tuner AGC | Einstellung des Tuner Ausgangspegels |
| CVBS | Videosignalausgang |
| SIF | Audiosignalausgang |
| $q\uparrow$ | maximale Regelabweichung bei Sprung von kleiner Informationssignalamplitude auf große Informationssignalamplitude |

q↓     maximale Regelabweichung bei Sprung von großer Informationssignalamplitude auf kleine Informationssignalamplitude

$E_{2,1}$     erster Eingang Mischer
$E_{2,2}$     zweiter Eingang Mischer
$E_7$     Eingang Bandpassfilter
$E_9$     Eingang A/D-Wandler
$E_{15}$     Eingang Synchron-Demodulator
$E_{18,I}$     IN-Phase-Signaleingang der Filtereinrichtung
$E_{18,Q}$     Quadratur-Signaleingang der Filtereinrichtung
$E_{21,1}$     erster Eingang der automatischen Verstärkungsregeleinrichtung für Tuner [???]-Signale
$E_{21,2}$     zweiter Eingang der automatischen Verstärkungsregeleinrichtung für Tuner [???]-Signale
$E_{23}$     Eingang der automatischen Verstärkungsregeleinrichtung für Videosignale
$E_{25}$     Eingang der automatischen Verstärkungsregeleinrichtung für Audiosignale
$E_{30}$     Eingang des A/D-Wandlers
$E_{31}$     Eingang des A/D-Wandlers
$E_{32}$     Eingang des A/D-Wandlers
$E_{36}$     Eingang digitaler I/Q-Oszillator
$E_{37,1}$     erster Eingang Regeleinrichtung
$E_{37,2}$     zweiter Eingang Regeleinrichtung
$E_{40,1}$     erster Eingang Mischer
$E_{40,2}$     zweiter Eingang Mischer
$E_{41,1}$     erster Eingang Mischer

$E_{41,2}$     zweiter Eingang Mischer
$E_{38}$     Eingang Tiefpassfilter
$E_{39}$     Eingang Tiefpassfilter
$E_{51,1}$     erster Eingang Tiefpassfilter
$E_{51,2}$     zweiter Eingang Tiefpassfilter
$E_{54,1}$     erster Eingang Recheneinheit
$E_{54,2}$     zweiter Eingang Recheneinheit
$E_{93}$     Eingang Tiefpassfilter
$E_{94}$     Eingang erstes Verzögerungsglied
$E_{95}$     Eingang zweites Verzögerungsglied
$E_{96,1}$     erster Eingang des ersten Subtrahierers
$E_{96,2}$     zweiter Eingang des ersten Subtrahierers
$E_{97,1}$     erster Eingang des zweiten Subtrahierers
$E_{97,2}$     zweiter Eingang des zweiten Subtrahierers
$E_{98,1}$     erster Eingang des Multiplizierers
$E_{98,2}$     zweiter Eingang des Multiplizierers
$E_{120}$     Eingang I-Regler
$E_{121,1}$     erster Eingang Subtrahierer
$E_{121,2}$     zweiter Eingang Subtrahierer

$A_2$     Ausgang Mischer
$A_7$     Ausgang Bandpassfilter
$A_9$     Ausgang A/D-Wandler
$A_{15,I}$     In-Phase-Signalausgang des Synchron-Demodulators
$A_{15,Q}$     Quadratur-Signalausgang des Synchron-Demodulators
$A_{18,I}$     In-Phase-Signalausgang der Filtereinrichtung
$A_{18,Q}$     Quadratur-Signalausgang der Filtereinrichtung
$A_{21}$     Ausgang der automatischen Verstärkungsregeleinrichtung für den Tuner-Ausgangspegel
$A_{23,1}$     erster Ausgang der automatischen Verstärkungsregelungseinrichtung für Videosignale
$A_{23,2}$     zweiter Ausgang der automatischen Verstärkungsregelungseinrichtung für Videosignale
$A_{25}$     Ausgang der automatischen Verstärkungsregelungseinrichtung für Audiosignale
$A_{11,1}$     erster Ausgang des DSP
$A_{11,2}$     zweiter Ausgang des DSP
$A_{11,3}$     dritter Ausgang des DSP

$A_{30}$     Ausgang des A/D-Wandlers
$A_{31}$     Ausgang des A/D-Wandlers
$A_{32}$     Ausgang des A/D-Wandlers
$A_{36}$     Ausgang digitaler I/Q-Oszillator
$A_{37,1}$    erster Ausgang Regeleinrichtung
$A_{37,2}$    zweiter Ausgang Regeleinrichtung
$A_{40,1}$    erster Ausgang Mischer
$A_{40,2}$    zweiter Ausgang Mischer
$A_{41,1}$    erster Ausgang Mischer
$A_{41,2}$    zweiter Ausgang Mischer
$A_{38}$     Ausgang Tiefpassfilter
$A_{39}$     Ausgang Tiefpassfilter
$A_{51,1}$    erster Ausgang Tiefpassfilter
$A_{51,2}$    zweiter Ausgang Tiefpassfilter
$A_{54,1}$    erster Ausgang Recheneinheit
$A_{54,2}$    zweiter Ausgang Recheneinheit
$A_{93}$     Ausgang Tiefpassfilter
$A_{94}$     Ausgang erstes Verzögerungsglied
$A_{95}$     Ausgang zweites Verzögerungsglied
$A_{96}$     Ausgang des ersten Subtrahierers
$A_{97}$     Ausgang des zweiten Subtrahierers
$A_{98}$     Ausgang des Multiplizierers
$A_{99}$     Ausgang des Tiefpassfilters
$A_{120}$    Ausgang I-Regler
$A_{121}$    Ausgang Subtrahierer

$\Delta I$     zeitlicher Amplitudenanstieg der In-Phase-Komponente
$\Delta Q$     differentielle Regelabweichung
I    In-Phase-Signal
Q    Quadratursignal
$\hat{U}_{BT}$    Amplitude des Bildträgers

$\vec{U}_{BT}$    Bildträger

$\hat{U}_{Qa}$    Amplitude des geschätzten störenden Quadraturkomponente im In-Phase-Signal
$\hat{U}_q$    Amplitude der orthogonalen Störung

$\vec{U}_q$    orthogonale Störung

$\hat{U}_{qa}$    Amplitude der geschätzten orthogonalen Störung

$\vec{U}_{qa}$    geschätzte orthogonale Störung
t    Zeit

**Patentansprüche**

**1.** Verfahren zur Unterdrückung einer störenden Quadraturkomponente $(35,\ \vec{U}_q)$ eines Trägersignals $(34,\ \vec{U}_{BT},\ 59)$ eines amplitudenmodulierten Signals (33, 33a, 33b) bei der Rückgewinnung des Trägersignals $(35,\ \vec{U}_q)$ in einem Synchrondemodulator (15), welcher ein Quadratursignal (Q) ausgibt,
**dadurch gekennzeichnet, dass**

die störende Quadraturkomponente $(35,\ \vec{U}_q)$ des Trägersignals $(34,\ \vec{U}_{BT},\ 59)$ abgeschätzt wird

und dass die abgeschätzte Quadraturkomponente $(35,\ \vec{U}_{qa})$ von dem Quadratursignal (Q) subtrahiert wird.

**2.** Verfahren nach Anspruch 1,
**dadurch gekennzeichnet, dass**

die störende Quadraturkomponente $(35, \vec{U}_q)$ des Trägersignals $(34, \vec{U}_{BT}, 59)$ aus einer Regelabweichung (q↑, q↓) des Quadratursignals (Q) und/oder einer Regelabweichung eines von dem Synchrondemodulator (15) ausgegebenen In-Phase-Signals (I) abgeschätzt wird.

**3.** Verfahren nach Anspruch 1,
**dadurch gekennzeichnet, dass**

die störende Quadraturkomponente $(35, \vec{U}_q)$ des Trägersignals $(34, \vec{U}_{BT}, 59)$ aus einem Integral (64, 65, 72) einer Regelabweichung (q↑, q↓) des Quadratursignals (Q) und/oder einem Integral einer Regelabweichung eines von dem Synchrondemodulator (15) ausgegebenen In-Phase-Signals (I) abgeschätzt wird.

**4.** Verfahren nach Anspruch 1,
 **dadurch gekennzeichnet, dass**

die störende Quadraturkomponente $(35, \vec{U}_q)$ des Trägersignals $(34, \vec{U}_{BT}, 59)$ aus einem Integral (64, 65, 72) der Regelabweichung (q↑, q↓) des Quadratursignals (Q) und/oder einem Integral einer Regelabweichung eines von dem Synchrondemodulator (15) ausgegebenen In-Phase-Signals (I), wobei das jeweilige Integral (64, 65, 72) mit einem Vorzeichen (+, -) einer Amplitudenänderung (62, 63, 67) eines die Regelabweichung (q↑, q↓) hervorrufenden Signals (61, 66) multipliziert wird, abgeschätzt wird.

**5.** Verfahren nach Anspruch 1,
**dadurch gekennzeichnet, dass**

die störende Quadraturkomponente $(35, \vec{U}_q)$ des Trägersignals $(34, \vec{U}_{BT}, 59)$ aus einem Integral (64, 65, 72) der Regelabweichung (q↑, q↓) des Quadratursignals (Q) und/oder einem Integral einer Regelabweichung eines von dem Synchrondemodulator (15) ausgegebenen In-Phase-Signals (I), wobei das jeweilige Integral (64, 65, 72) mit einem Vorzeichen (+, -) einer Amplitudenänderung (62, 63, 67) des In-Phase-Signals (I, 61, 66) multipliziert wird, abgeschätzt wird.

**6.** Verfahren nach Anspruch 1,
**dadurch gekennzeichnet, dass**

die störende Quadraturkomponente $(35, \vec{U}_q)$ des Trägersignals $(34, \vec{U}_{BT}, 59)$ aus einer differentiellen Regelabweichung (ΔQ, 73, 75, 77) des Quadratursignals (Q) und/oder einer differentiellen Regelabweichung einer von dem Synchrondemodulator (15) ausgegebenen In-Phase-Signals (I), wobei die jeweilige differentielle Regelabweichung (ΔQ, 73, 75, 77) mit einer Amplitudenänderung (79, 81, 83, 85) des In-Phase-Signals (I, 61, 66) multipliziert wird, abgeschätzt wird.

**7.** Verfahren nach einem der vorangegangenen Ansprüche,
**dadurch gekennzeichnet, dass**

die abgeschätzte Quadraturkomponente $(35, \vec{U}_{qa})$ vor der Subtraktion von dem Quadratursignal (Q) tiefpassgefiltert wird.

**8.** Verfahren nach einem der vorangegangenen Ansprüche,
**dadurch gekennzeichnet, dass**

die, ggf. tiefpassgefilterte, abgeschätzte Quadraturkomponente $(35, \vec{U}_{qa})$ mit Hilfe einer rückgeführten Regelschleife, insbesondere einem I-Regler (119), von dem Quadratursignal (Q) subtrahiert wird.

**9.** Verfahren zur Abschätzung einer störenden Quadraturkomponente $(35, \vec{U}_q)$ eines Trägersignals

$(34, \vec{U}_{BT}, 59)$ eines amplitudenmodulierten Signals (33, 33a, 33b) durch Auswertung einer Regelabweichung (q↑, q↓) eines von einem Synchrondemodulator (15) ausgegebenen Quadratursignals (Q) und/oder durch Auswertung einer Regelabweichung eines von dem Synchrondemodulator (15) ausgegebenen In-Phase-Signals (I).

**10.** Verfahren zur Abschätzung einer störenden Quadraturkomponente $(35, \vec{U}_q)$ eines Trägersignals $(34, \vec{U}_{BT}, 59)$ eines amplitudenmodulierten Signals (33, 33a, 33b) durch Auswertung eines Integrals (64, 65, 72) einer Regelabweichung (q↑, q↓) eines von einem Synchrondemodulator (15) ausgegebenen Quadratursignals (Q) und/oder durch Auswertung eines Integrals einer Regelabweichung eines von dem Synchrondemodulator (15) ausgegebenen In-Phase-Signals (I).

**11.** Verfahren zur Abschätzung einer störenden Quadraturkomponente $(35, \vec{U}_q)$ eines Trägersignals $(34, \vec{U}_{BT}, 59)$ eines amplitudenmodulierten Signals (33, 33a, 33b) durch Auswertung eines Integrals (64, 65, 72) einer Regelabweichung (q↑, q↓) eines von einem Synchrondemodulator (15) ausgegebenen Quadratursignals (Q) und/oder durch Auswertung eines Integrals einer Regelabweichung eines von dem Synchrondemodulator (15) ausgegebenen In-Phase-Signals (I), wobei das jeweilige Integral (64, 65, 72) mit einem Vorzeichen (+, -) einer Amplitudenänderung (62, 63, 67) eines die Regelabweichung (q↑, q↓) hervorrufenden Signals (61, 66) multipliziert wird.

**12.** Verfahren zur Abschätzung einer störenden Quadraturkomponente $(35, \vec{U}_q)$ eines Trägersignals $(34, \vec{U}_{BT}, 59)$ eines amplitudenmodulierten Signals (33, 33a, 33b) durch Auswertung eines Integrals (64, 65, 72) einer Regelabweichung (q↑, q↓) eines von einem Synchrondemodulator (15) ausgegebenen Quadratursignals (Q) und/oder durch Auswertung eines Integrals einer Regelabweichung eines von dem Synchrondemodulator (15) ausgegebenen In-Phase-Signals (I), wobei das jeweilige Integral (64, 65, 72) mit einem Vorzeichen (+, -) einer Amplitudenänderung (62, 63, 67) des In-Phase-Signals (I, 61, 66) multipliziert wird.

**13.** Verfahren zur Abschätzung einer störenden Quadraturkomponente $(35, \vec{U}_q)$ eines Trägersignals $(34, \vec{U}_{BT}, 59)$ eines amplitudenmodulierten Signals (33, 33a, 33b) durch Auswertung einer differentiellen Regelabweichung (ΔQ, 73, 75, 77) eines von einem Synchrondemodulator (15) ausgegebenen Quadratursignals (Q) und/oder durch Auswertung einer differentiellen Regelabweichung eines von dem Synchrondemodulator (15) ausgegebenen In-Phase-Signals (I), wobei die jeweilige differentielle Regelabweichung (ΔQ, 73, 75, 77) mit einer Amplitudenänderung (79, 81, 83, 85) des In-Phase-Signals (I, 61, 66) multipliziert wird.

**14.** Schaltungsanordnung (115) zur Unterdrückung einer störenden Quadraturkomponente $(35, \vec{U}_q)$ eines Trägersignals $(34, \vec{U}_{BT}, 59)$ eines amplitudenmodulierten Signals (33, 33a, 33b) bei der Rückgewinnung des Trägersignals $(35, \vec{U}_q)$ in einem Synchrondemodulator (15), welcher ein Quadratursignal (Q) ausgibt, **dadurch gekennzeichnet, dass**

eine Störungsabschätzeinrichtung (90) zur Abschätzung der störenden Quadraturkomponente $(35, \vec{U}_q)$ des Trägersignals $(34, \vec{U}_{BT}, 59)$ vorgesehen ist und dass eine Subtraktionseinrichtung (121) zum Subtrahieren der abgeschätzten Quadraturkomponente $(35, \vec{U}_{qa})$ von dem Quadratursignal (Q) vorgesehen ist.

**15.** Schaltungsanordnung nach Anspruch 14, **dadurch gekennzeichnet, dass**

die Störungsabschätzeinrichtung (90) zur Abschätzung der störenden Quadraturkomponente $(35, \vec{U}_q)$ des Trägersignals $(34, \vec{U}_{BT}, 59)$ aus einer Regelabweichung (q↑, q↓) des Quadratursignals (Q) und/oder einer Regelabweichung einer von dem Synchrondemodulator (15) ausgegebenen In-Phase-Signals (I) ausgebildet ist.

16. Schaltungsanordnung nach Anspruch 14,
**dadurch gekennzeichnet , dass**

die Störungsabschätzeinrichtung (90) zur Abschätzung der störenden Quadraturkomponente $(35, \vec{U}_q)$ des Trägersignals $(34, \vec{U}_{BT}, 59)$ aus einem Integral (64, 65, 72) einer Regelabweichung (q↑, q↓) des Quadratursignals (Q) und/oder einem Integral einer Regelabweichung eines von dem Synchrondemodulator (15) ausgegebenen In-Phase-Signals (I) ausgebildet ist.

17. Schaltungsanordnung nach Anspruch 14,
**dadurch gekennzeichnet, dass**

die Störungsabschätzeinrichtung (90) zur Abschätzung der störenden Quadraturkomponente $(35, \vec{U}_q)$ des Trägersignals $(34, \vec{U}_{BT}, 59)$ aus einem Integral (64, 65, 72) der Regelabweichung (q↑, q↓) des Quadratursignals (Q) und/oder einem Integral einer Regelabweichung eines von dem Synchrondemodulator (15) ausgegebenen In-Phase-Signals (I), wobei das jeweilige Integral (64, 65, 72) mit einem Vorzeichen (+, -) einer Amplitudenänderung (62, 63, 67) eines die Regelabweichung (q↑, q↓) hervorrufenden Signals (61, 66) multipliziert wird, ausgebildet ist.

18. Schaltungsanordnung nach Anspruch 14,
**dadurch gekennzeichnet, dass**

die Störungsabschätzeinrichtung (90) zur Abschätzung der störenden Quadraturkomponente $(35, \vec{U}_q)$ des Trägersignals $(34, \vec{U}_{BT}, 59)$ aus einem Integral (64, 65, 72) der Regelabweichung (q↑, q↓) des Quadratursignals (Q) und/oder einem Integral einer Regelabweichung eines von dem Synchrondemodulator (15) ausgegebenen In-Phase-Signals (I), wobei das jeweilige Integral (64, 65, 72) mit einem Vorzeichen (+, -) einer Amplitudenänderung (62, 63, 67) des In-Phase-Signals (I, 61, 66) multipliziert wird, ausgebildet ist.

19. Schaltungsanordnung nach Anspruch 14,
**dadurch gekennzeichnet, dass**

die Störungsabschätzeinrichtung (90) zur Abschätzung der störenden Quadraturkomponente $(35, \vec{U}_q)$ des Trägersignals $(34, \vec{U}_{BT}, 59)$ aus einer differentiellen Regelabweichung (ΔQ, 73, 75, 77) des Quadratursignals (Q) und/oder einer differentiellen Regelabweichung einer von dem Synchrondemodulator (15) ausgegebenen In-Phase-Signals (I), wobei die jeweilige differentielle Regelabweichung (ΔQ, 73, 75, 77) mit einer Amplitudenänderung (79, 81, 83, 85) des In-Phase-Signals (I, 61, 66) multipliziert wird, ausgebildet ist.

20. Schaltungsanordnung nach einem der Ansprüche 14 bis 19,
**dadurch gekennzeichnet, dass**

ein Tiefpassfilter (93) zum tiefpassfiltern der abgeschätzten Quadraturkomponente $(35, \vec{U}_{qa})$ vor der Subtraktion von dem Quadratursignal (Q) vorgesehen ist.

21. Schaltungsanordnung nach einem der Ansprüche 14 bis 20,

**dadurch gekennzeichnet, dass**

einer rückgeführten Regelschleife, insbesondere ein I-Regler (119), vorgesehen ist, um die, ggf. tiefpassgefilterte, abgeschätzte Quadraturkomponente $(35, \vec{U}_{qa})$ von dem Quadratursignal (Q) zu subtrahieren.

22. Störungsabschätzeinrichtung (90) zur Abschätzung der störenden Quadraturkomponente $(35, \vec{U}_q)$ des Trägersignals $(34, \vec{U}_{BT}, 59)$ mit einer Erfassungseinrichtung zu einer Erfassung einer Regelabweichung (q↑, q↓) eines von einem Synchrondemodulator (15) ausgegebenen Quadratursignals (Q) und/oder zu einer Erfassung einer Regelabweichung eines von dem Synchrondemodulator (15) ausgegebenen In-Phase-Signals (I).

23. Störungsabschätzeinrichtung (90) zur Abschätzung der störenden Quadraturkomponente $(35, \vec{U}_q)$ des Trägersignals $(34, \vec{U}_{BT}, 59)$ mit einer Erfassungseinrichtung zu einer Erfassung einer Regelabweichung (q↑, q↓) eines von einem Synchrondemodulator (15) ausgegebenen Quadratursignals (Q) und/oder zu einer Erfassung einer Regelabweichung eines von dem Synchrondemodulator (15) ausgegebenen In-Phase-Signals (I) und mit einer Integriereinrichtung zum Bilden eines Integrals (64, 65, 72) der Regelabweichung (q↑, q↓) des von dem Synchrondemodulator (15) ausgegebenen Quadratursignals (Q) und/oder zum Bilden eines Integrals der Regelabweichung des von dem Synchrondemodulator (15) ausgegebenen In-Phase-Signals (I).

24. Störungseinrichtung (90) nach Anspruch 22 oder 23,
    **dadurch gekennzeichnet, dass**
    aus der Regelabweichung durch Integration und gegebenenfalls notwendiger Vorzeichenkorrektur die Quadraturkomponente abgeschätzt wird.

25. Störungsabschätzeinrichtung (90) zur Abschätzung der störenden Quadraturkomponente $(35, \vec{U}_q)$ des Trägersignals $(34, \vec{U}_{BT}, 59)$ mit einer Erfassungseinrichtung zu einer Erfassung einer Regelabweichung (q↑, q↓) eines von einem Synchrondemodulator (15) ausgegebenen Quadratursignals (Q) und/oder zu einer Erfassung einer Regelabweichung eines von dem Synchrondemodulator (15) ausgegebenen In-Phase-Signals (I) und mit einer Integriereinrichtung zum Bilden eines Integrals (64, 65, 72) der Regelabweichung (q↑, q↓) des von dem Synchrondemodulator (15) ausgegebenen Quadratursignals (Q) und/oder zum Bilden eines Integrals der Regelabweichung des von dem Synchrondemodulator (15) ausgegebenen In-Phase-Signals (I) und mit einer Multipliziereinrichtung zum Multiplizieren des jeweiligen Integrals (64, 65, 72) mit einem Vorzeichen (+, -) einer Amplitudenänderung (62, 63, 67) eines die Regelabweichung (q↑, q↓) hervorrufenden Signals (61, 66).

26. Störungsabschätzeinrichtung (90) zur Abschätzung der störenden Quadraturkomponente $(35, \vec{U}_q)$ des Trägersignals $(34, \vec{U}_{BT}, 59)$ mit einer Erfassungseinrichtung zu einer Erfassung einer Regelabweichung (q↑, q↓) eines von einem Synchrondemodulator (15) ausgegebenen Quadratursignals (Q) und/oder zu einer Erfassung einer Regelabweichung eines von dem Synchrondemodulator (15) ausgegebenen In-Phase-Signals (I) und mit einer Integriereinrichtung zum Bilden eines Integrals (64, 65, 72) der Regelabweichung (q↑, q↓) des von dem Synchrondemodulator (15) ausgegebenen Quadratursignals (Q) und/oder zum Bilden eines Integrals der Regelabweichung des von dem Synchrondemodulator (15) ausgegebenen In-Phase-Signals (I) und mit einer Multipliziereinrichtung zum Multiplizieren des jeweiligen Integrals (64, 65, 72) mit einem Vorzeichen (+, -) einer Amplitudenänderung (62, 63, 67) des In-Phase-Signals (I, 61, 66).

27. Störungsabschätzeinrichtung (90) zur Abschätzung der störenden Quadraturkomponente $(35, \vec{U}_q)$ des Trägersignals $(34, \vec{U}_{BT}, 59)$ mit einer Differenziereinrichtung (96, 97) zum Bilden einer differentiellen Regelabweichung (ΔQ, 73, 75, 77) eines von einem Synchrondemodulator (15) ausgegebenen Quadratursignals (Q) und/oder zum Bilden einer differentiellen Regelabweichung einer von dem Synchrondemodulator (15) ausgegebenen In-Phase-Signals (I), mit einer Differenziereinrichtung (94, 95) zum Bestimmen einer Amplitudenänderung (79, 81, 83, 85) des In-Phase-Signals (I, 61, 66) und mit einer Multipliziereinrichtung zum Multiplizieren der jeweiligen differentiellen Regelabweichung (ΔQ, 73, 75, 77) mit der Amplitudenänderung (79, 81, 83, 85) des In-Phase-Signals (I, 61, 66).

FIG 1a

FIG 1b

34 33a 33b

$Q$ $Q'$

@

$q\uparrow < 0$

b

I

I'

$|q\uparrow| > |q\downarrow|$

59 35

$Q$ $Q'$

$q\downarrow > 0$

@

I

b

I'

FIG 2a  I (≈Amplitude)  61 63 68 66 67

b

62

a

t

FIG 2b  Q (≈Regelabweichung)

65

64

$q\downarrow$

$q\uparrow$

71 69

68
70
72

t

FIG 2c  ΔI

79

81

83

85

t

FIG 2d  ΔQ

73

75

77

t

FIG 2e  $\hat{U}q = $ ΔI ΔQ

88

87

113

89

t

FIG 3

FIG 4

# FIG 5

EP 1 643 633 A1

FIG 6 (Stand der Technik)

EP 1 643 633 A1

FIG 7b

33

$\vec{U}_{BT} + \vec{U}_q$

$\vec{U}_{BT}$

$\Delta \varphi$

34

35 59

I

Q

$U_{BT}$

$U_q$

FIG 7a (Stand der Technik)

33

$f_{BT} + f_{picture}$

OSB

$\hat{U}_{BT}$ m$\hat{U}_{BT}$

USB

$f_{BT} - f_{picture}$

34

I

Q

FIG 8 (Stand der Technik)

EP 1 643 633 A1

FIG 9a (Stand der Technik)    FIG 9b

CVBS

60000
50000
40000
30000
20000
10000

250  500  750  1000  1250  1500

t

CVBS

60000
50000
40000
30000

250  500  750  1000  1250  1500

t

EP 1 643 633 A1

**Europäisches Patentamt**

**EUROPÄISCHER RECHERCHENBERICHT**

Nummer der Anmeldung

EP 05 02 0455

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 01/05025 A (SIEMENS AG) 18. Januar 2001 (2001-01-18) * Seite 5, Zeile 18 - Seite 8, Zeile 5; Abbildungen 1-5 * ----- | 1 | H03D1/22 |
| A | US 2003/203728 A1 (D FILIPOVIC) 30. Oktober 2003 (2003-10-30) * Absatz [0016] - Absatz [0050]; Abbildung 4 * ----- | 1-27 | |
| A | US 2002/097812 A1 (J WISS) 25. Juli 2002 (2002-07-25) * Absatz [0058] - Absatz [0062]; Abbildung 5 * ----- | 1-27 | |
| A | US 4 729 110 A (K WELLES) 1. März 1988 (1988-03-01) * Abbildung 1 * ----- | 1-27 | |
| A | US 4 484 194 A (E ARVIDSON) 20. November 1984 (1984-11-20) * Abbildungen 5,6 * ----- | 1-27 | RECHERCHIERTE SACHGEBIETE (IPC) |
| A | EP 0 948 128 A (MOTOROLA) 6. Oktober 1999 (1999-10-06) * Abbildung 1 * ----- | 1-27 | H03D |

Der vorliegende Recherchenbericht wurde für alle Patentansprüche erstellt

| Recherchenort | Abschlußdatum der Recherche | Prüfer |
|---|---|---|
| Den Haag | 11. November 2005 | Butler, N |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

                                                
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 05 02 0455

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-11-2005

| Im Recherchenbericht angeführtes Patentdokument | | Datum der Veröffentlichung | Mitglied(er) der Patentfamilie | | Datum der Veröffentlichung |
|---|---|---|---|---|---|
| WO 0105025 | A | 18-01-2001 | CN<br>EP<br>HU<br>JP | 1360751 A<br>1195001 A1<br>0201819 A2<br>2003504927 T | 24-07-2002<br>10-04-2002<br>28-09-2002<br>04-02-2003 |
| US 2003203728 | A1 | 30-10-2003 | AU<br>CA<br>EP<br>JP<br>WO | 2003231116 A1<br>2483511 A1<br>1500184 A1<br>2005524272 T<br>03092152 A1 | 10-11-2003<br>06-11-2003<br>26-01-2005<br>11-08-2005<br>06-11-2003 |
| US 2002097812 | A1 | 25-07-2002 | KEINE | | |
| US 4729110 | A | 01-03-1988 | KEINE | | |
| US 4484194 | A | 20-11-1984 | DE<br>EP<br>SE | 3166625 D1<br>0048229 A2<br>419581 B | 15-11-1984<br>24-03-1982<br>10-08-1981 |
| EP 0948128 | A | 06-10-1999 | US | 6075409 A | 13-06-2000 |

EPO FORM P0461

Für nähere Einzelheiten zu diesem Anhang : siehe Amtsblatt des Europäischen Patentamts, Nr.12/82